## Europäisches Patentamt

## European Patent Office

## Office européen des brevets

(19)

(11)  **EP 0 698 897 B1**

(12)  **EUROPÄISCHE PATENTSCHRIFT**

(45) Veröffentlichungstag und Bekanntmachung des Hinweises auf die Patenterteilung:
 **16.05.2001   Patentblatt 2001/20**

(51) Int Cl.⁷: **H01F 38/30**, H01F 27/36, G01R 15/18

(21) Anmeldenummer: **95810499.4**

(22) Anmeldetag: **08.08.1995**

(54) **Stromwandler für eine metallgekapselte gasisolierte Hochspannungsanlage**

Current transformer for a metal-encapsulated, gas-insulated high voltage installation

Transformateur de courant pour une installation haute tension à encapsulation métallique et à gaz isolant

(84) Benannte Vertragsstaaten:
 **CH DE FR GB LI**

(30) Priorität: **24.08.1994  DE 4429959**

(43) Veröffentlichungstag der Anmeldung:
 **28.02.1996   Patentblatt 1996/09**

(60) Teilanmeldung:
 **98119506.8 / 0 889 490**

(73) Patentinhaber: **ABB Hochspannungstechnik AG**
 **8050 Zürich (CH)**

(72) Erfinder: **Kaczkowski, Andrzej, Dr.**
 **CH-5303 Würenlingen (CH)**

(74) Vertreter: **ABB Patent Attorneys**
 **c/o ABB Business Services Ltd. (SLE-I)**
 **Haselstrasse 16/699**
 **5401 Baden (CH)**

(56) Entgegenhaltungen:
 **EP-A- 0 510 426        CH-A- 607 264**
 **DE-A- 2 548 376        DE-A- 3 544 508**
 **FR-A- 1 477 932        FR-A- 2 564 594**
 **GB-A- 2 197 544        US-A- 3 701 003**

 • **IEEE TRANSACTIONS ON INSTRUMENTATION AND MEASUREMENT, Bd. 23, Nr. 4, Dezember 1974 NEW YORK US, Seiten 261-263, K. GROHMANN ET AL. 'Ironless cryogenic current comparators for AC and DC applications'**

**Beschreibung**

TECHNISCHES GEBIET

Bei der Erfindung wird ausgegangen von einem Stromwandler für eine metallgekapselte gasisolierte Hochspannungsanlage gemäss dem Oberbegriff des Anspruchs 1.

STAND DER TECHNIK

Die Erfindung nimmt dabei Bezug auf einen Stand der Technik, wie er sich beispielsweise aus der Schrift EP-A2-0 522 303 ergibt. Der dort beschriebene kombinierte Messwandler ist für eine metallgekapselte, gasisolierte Hochspannungsanlage bestimmt. Er weist einen Strom- und Spannungssensor und eine dem Strom- und Spannungssensor nachgeschaltete Signalverarbeitungsvorrichtung auf. Als Stromsensor dient eine Rogowskispule, die um einen ringförmigen Kern aus nicht ferromagnetischem, überwiegend isotropem Material gewickelt ist. Als Spannungssensor ist eine hohlzylindrisch ausgebildete Messelektrode vorgesehen. Nach dem Einbau des Strom- und Spannungssensors in die Metallkapselung umgeben die Spule und die Messelektrode einen Stromleiter der gasisolierten Schaltanlage konzentrisch.

Die Rogowskispule ist in einen ringförmigen Isolierkörper eingebettet, der in einem ringförmigen Raum angeordnet ist. Die Wände des Raums bestehen aus elektrisch leitendem Material, vorzugsweise aus einer Aluminiumlegierung. Der Isolierkörper ist in diesem Raum fixiert. Der Raum ist an seiner dem Stromleiter zugewandten Mantelfläche von einer flächenhaften, ringförmigen Abschirmelektrode begrenzt. Die eine Stirnseite dieser Abschirmelektrode ist in elektrisch leitender Weise mit der Wand auf der einen Seite des ringförmigen Raums verbunden, während die dieser gegenüberliegende Stirnseite in elektrisch isolierender Weise mit der Wand auf der anderen Seite des ringförmigen Raums verbunden ist. Als isolierende Verbindung ist hier ein vergleichsweise schmaler, vollständig mit Isoliermaterial gefüllter Spalt vorgesehen. Die Wände des ringförmigen Raumes bilden mit der Abschirmelektrode eine elektrisch leitende Abschirmung. Diese Abschirmung schützt den ringförmigen Raum vor dem Einfluss elektrischer Störfelder. Beim Messen in der Hochspannungsanlage unter Betriebsbedingungen werden daher von der Rogowskispule Signale abgegeben, die frei sind von Beeinflussungen durch die elektrischen Störfelder. Die Rogowskispule liefert dem Betrag und der zeitlichen Änderung des im Stromleiter der gasisolierten Schaltanlage fliessenden Stromes proportionale Signale, welche aufgrund der geeignet angeordneten. Abschirmung nahezu frei von den Einflüssen elektrischer Fremdfelder sind. Für viele praktische Anwendungen dürfte ein derart aufgebauter Stromwandler durchaus genügen.

Der mit Isoliermaterial gefüllte Spalt in der die Rogowskispule umgebenden Abschirmung ist jedoch die Ursache dafür, dass schnelle und sehr schnelle transiente elektrische Störungen, etwa in einem Frequenzbereich von grösser als 1 MHz bis etwa mehrere GHz, nicht von der Rogowskispule ferngehalten werden. Derartige Störungen verfälschen das Messignal, sie können zudem die Ursache dafür sein, dass der stets vorhandene Überspannungsschutz am Eingang der Signalverarbeitungsvorrichtung überbeansprucht wird.

Aus der Offenlegungsschrift DE 35 44 508 A1 ist ein Kombinationswandler bekannt, der eine in Längsrichtung geschlitzte Metallfolie als Abschirmung aufweist. Durch den Schlitz können hochfrequente Störungen in den Bereich der Messwicklung eindringen und das Messergebnis verfälschen.

Aus der Europäischen Patentanmeldung EP 0 510 426 A2 ist ein Stromwandler bekannt gemäss dem Oberbegriff des Auspruchs 1. Die als Rogowskispule ausgebildete Messwicklung ist von einer Abschirmung umgeben. Diese Abschirmung weist einen als Isolierstelle ausgebildeten Spalt auf, der hochfrequente Störungen nicht in jedem Fall von der Messwicklung fern halten kann.

Aus der Patentschrift US 3,701,003 ist ein Stromwandler bekannt, der einen mit ohmschen Widerständen überbrückten Spalt in seiner metallischen Abschirmung aufweist.

Aus der Patentanmeldung GB 2 197 544 A ist ein Transformator bekannt, der für Datenübertragungen eingesetzt wird. Dieser Transformator weist einen aus zwei Halbschalen aufgebauten Kern auf, welcher die Primärwindung umschliesst. Die Sekundärwicklung wird aussen auf den Kern aufgebracht. Zwischen den Halbschalen ist ein labyrinthförmig ausgebildeter Spalt vorgesehen. Dieser Spalt dient der Regelung des magnetischen Flusses durch den Tansformatorkern.

DARSTELLUNG DER ERFINDUNG

Der Erfindung, wie sie in den unabhängigen Patentansprüchen angegeben ist, liegt die Aufgabe zugrunde, einen Stromwandler für metallgekapselte gasisolierte Hochspannungsanlagen anzugeben, welcher auch gegen extrem hochfrequente elektrische Störungen unempfindlich ist, welcher kostengünstig zu erstellen ist, und welcher sich durch geringe Abmessungen und durch eine hohe Messgenauigkeit auszeichnet.

Der Stromwandler nach der Erfindung zeichnet sich dadurch aus, dass er gegen hochfrequente Störungen geschützt ist. Der Stromwandler weist einen torusförmig ausgebildeten, eine Strombahn umschliessenden Stromsensor und eine diesem nachgeschaltete Signalverarbeitungsvorrichtung auf. Er weist ferner einen den Stromsensor umgebenden und von einer elektrisch leitenden Abschirmung eingeschlossenen ringförmigen Hohlraum auf, der mit einer Masse aufgefüllt ist. Zudem ist er mit mindestens einem umlaufenden, als Unterbrechung der Abschirmung ausgelegten Spalt versehen. Diese mindestens eine Unterbrechung der Abschirmung ist so ausgelegt, dass sie im Normalbetrieb des Stromwandlers voll wirksam ist, und dass sie beim Auftreffen von hochfrequenten Störungen überbrückt ist. Die hochfrequente Störung wird demnach unschädlich gemacht, während gleichzeitig die Messwerterfassung im Stromwandler unbeeinflusst weiter geht. Der Spalt ist labyrinthförmig ausgebildet. Für seine Überbrückung sind leitende oder halbleitende Mittel vorgesehen.

Als leitendes Mittel sind bei einer Ausführungsform diskrete ohmsche Widerstände vorgesehen. Als leitendes oder halbleitendes Mittel sind aber auch entsprechend dotierte und den Spalt füllende Kunststoffe möglich, oder auch eine entsprechend dotierte, vorzugsweise als Rundschnurring ausgebildete, den Spalt abschliessende Dichtung.

Die weiteren Ausgestaltungen der Erfindung sind Gegenstände der abhängigen Ansprüche.

Die Erfindung, ihre Weiterbildung und die damit erzielbaren Vorteile werden nachfolgend anhand der Zeichnung, welche lediglich einen möglichen Ausführungsweg darstellt, näher erläutert.

KURZE BESCHREIBUNG DER ZEICHNUNG

Es zeigen:

Fig.1 einen Schnitt durch einen schematisch dargestellten Stromwandler, welcher als Stand der Technik betrachtet wird,

Fig.2 einen Schnitt durch eine schematisch dargestellte erste Ausführungsform eines erfindungsgemässen Stromwandlers,

Fig.3 einen Schnitt durch eine schematisch dargestellte zweite Ausführungsform eines erfindungsgemässen Stromwandlers,

Fig.4 einen Schnitt durch eine schematisch dargestellte dritte Ausführungsform eines erfindungsgemässen Stromwandlers,

Fig. 5 einen Schnitt durch eine schematisch dargestellte vierte Ausführungsform eines erfindungsgemässen Stromwandlers, und

Fig. 6 ein stark vereinfachtes elektrisches Ersatzschaltbild eines erfindungsgemässen Stromwandlers.

Bei allen Figuren sind gleich wirkende Elemente mit gleichen Bezugszeichen versehen. Alle für das unmittelbare Verständnis der Erfindung nicht erforderlichen Elemente sind nicht dargestellt.

WEGE ZUR AUSFÜHRUNG DER ERFINDUNG

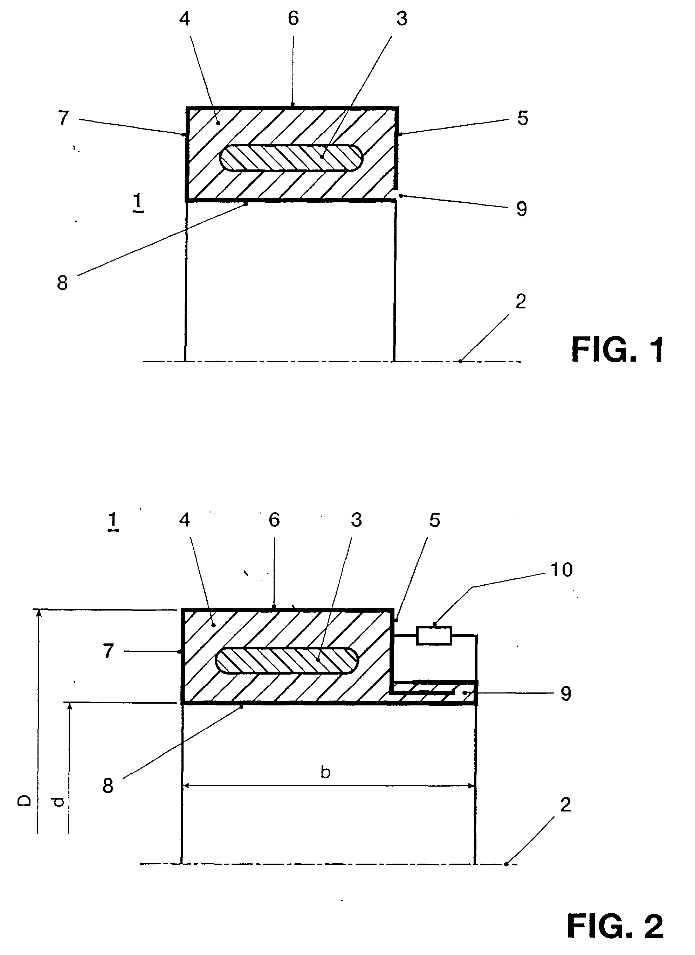

Die Fig.1 zeigt einen Schnitt durch einen schematisch dargestellten, ringförmig ausgebildeten Stromwandler 1, welcher als Stand der Technik betrachtet wird. Dieser Stromwandler 1 umgibt einen Stromleiter der metallgekapselten gasisolierten Schaltanlage konzentrisch. Von diesem Stromleiter ist lediglich die Mittelachse 2 dargestellt, die bei einer einphasig metallgekapselten gasisolierten Schaltanlage gleichzeitig die Mittelachse der Metallkapselung ist. Als Stromsensor dient hier eine Rogowskispule 3, die um einen ringförmigen, nicht bezeichneten Kern aus nicht ferromagnetischem, überwiegend isotropem Material gewickelt ist. Es können jedoch auch andere torusförmig ausgebildete Stromsensoren an dieser Stelle eingesetzt werden. Die von der Rogowskispule 3 weg in eine nicht dargestellte Signalverarbeitungsvorrichtung führenden Signalleitungen sind ebenfalls nicht dargestellt. Die Rogowskispule 3 ist in einem mit einer elektrisch isolierenden Masse 4 aufgefüllten, ringförmig ausgebildeten Hohlraum mit rechteckigem Querschnitt angeordnet. Die Begrenzung des Hohlraums erfolgt durch als Abschirmung wirkende elektrisch leitende Wände 5,6,7,8, die durch Linien angedeutet sind, die eine etwas grössere Strichdicke aufweisen. Die konstruktive Ausbildung der die Wände 5,6,7,8 bildenden Bauelemente soll hier nicht näher beschrieben werden. Diese Bauelemente können beispielsweise ähnlich ausgebildet sein, wie in der Schrift EP-A2-0 522 303 dargestellt. Ist in der metallgekapselten gasisolierten Schaltanlage mehr als ein Stromleiter vorgesehen, so umgeben die Stromwandler und die eventuell mit diesen verbundenen Spannungssensoren den jeweils zugeordneten Stromleiter zwar konzentrisch, weisen dann jedoch nicht die gleiche Mittelachse auf wie die Metallkapselung.

Zwischen der Wand 8 und der Wand 5 verbleibt bei dieser Ausführung des Stromwandlers 1 ein vergleichsweise schmaler Spalt 9, der um den gesamten Umfang dieses Stromwandlers 1 herumläuft. Dieser Spalt 9 ist ebenfalls mit der isolierenden Masse 4 ausgefüllt. Durch den Spalt 9 wird verhindert, dass durch die Abschirmung induzierte Streuströme fliessen können, wodurch das die Rogowskispule 3 durchsetzende magnetische Feld verfälscht würde, was zu einer Beeinträchtigung der Messgenauigkeit des Stromwandlers führen würde. Wenn die Abschirmung elektrisch leitend mit der metallischen Kapselung der gasisolierten Schaltanlage verbunden ist, verhindert der Spalt 9 zudem, dass Teile des durch die Metallkapselung der gasisolierten Schaltanlage fliessenden Kapselungsstroms, durch die Wand 8 fliessen können, was ebenfalls eine Beeinträchtigung der Messgenauigkeit des Stromwandlers zur Folge hätte. Die Metallwände des Spalts 9 sollen zudem ein Eindringen von elektrischen Störfeldern in den unmittelbaren Bereich der Rogowskispule 3 verhindern. Schnelle und sehr schnelle transiente elektromagnetische Störungen, etwa in einem Frequenzbereich von grösser als 1 MHz bis etwa mehrere GHz, werden dadurch jedoch nicht von der Rogowskispule ferngehalten.

Die Fig.2 zeigt einen Schnitt durch eine schematisch dargestellte erste Ausführungsform eines erfindungsgemässen Stromwandlers 1. Dieser unterscheidet sich vom Stromwandler 1 gemäss Fig.1' lediglich dadurch, dass der Spalt 9 labyrinthförmig ausgebildet ist und durch eine Parallelschaltung einer Anzahl diskreter ohmscher Widerstände 10 elektrisch leitend überbrückt wird. Die ohmschen Widerstände 10 sind gleichmässig auf dem Umfang des Stromwandlers 1 verteilt, sie bilden eine Art Käfig. Das Mass b gibt die in Richtung der Mittelachse 2 erstreckte axiale Ausbreitung der Abschirmung an, das Mass D gibt den Aussendurchmesser der Abschirmung an und das Mass d gibt den Innendurchmesser der Abschirmung an.

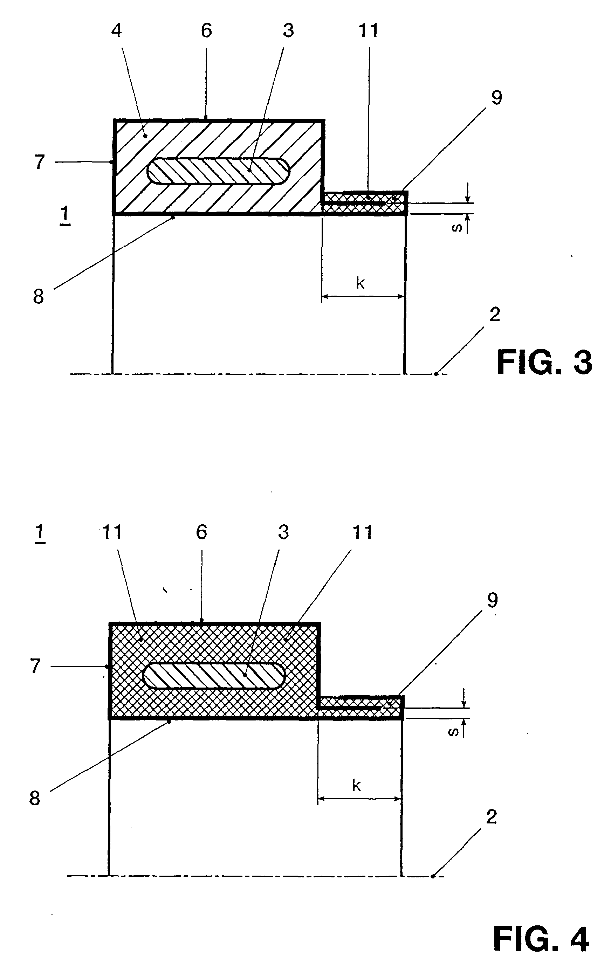

Fig.3 zeigt einen Schnitt durch eine schematisch dargestellte zweite Ausführungsform eines erfindungsgemässen Stromwandlers. Bei dieser Ausführungsform wird die Funktion der ohmschen Widerstände 10 durch eine schwach leitende oder halbleitende Masse 11 übernommen, mit welcher hier der labyrinthförmig ausgebildete Spalt 9 vollständig ausgefüllt ist. Der übrige Aufbau dieses Stromwandlers 1 entspricht dem der in Fig.2 gezeigten Ausführungsform. Der spezifische Widerstand σ der leitenden oder halbleitenden Masse 11 wird in diesem Fall vorzugsweise im Bereich von 100 μΩm bis 1 mΩm liegen.

Fig.4 zeigt einen Schnitt durch eine schematisch dargestellte dritte Ausführungsform eines erfindungsgemässen Stromwandlers 1. Bei diesem Stromwandler 1 ist nicht nur der labyrinthförmig ausgebildete Spalt 9 mit der halbleitenden Masse 11 aufgefüllt, sondern auch der gesamte durch die Wände 5,6,7,8 eingeschlossene ringförmige Hohlraum. Der spezifische Widerstand σ der leitenden oder halbleitenden Masse 11 wird in diesem Fall vorzugsweise ebenfalls im Bereich von 100 μΩm bis 1 mΩm liegen.

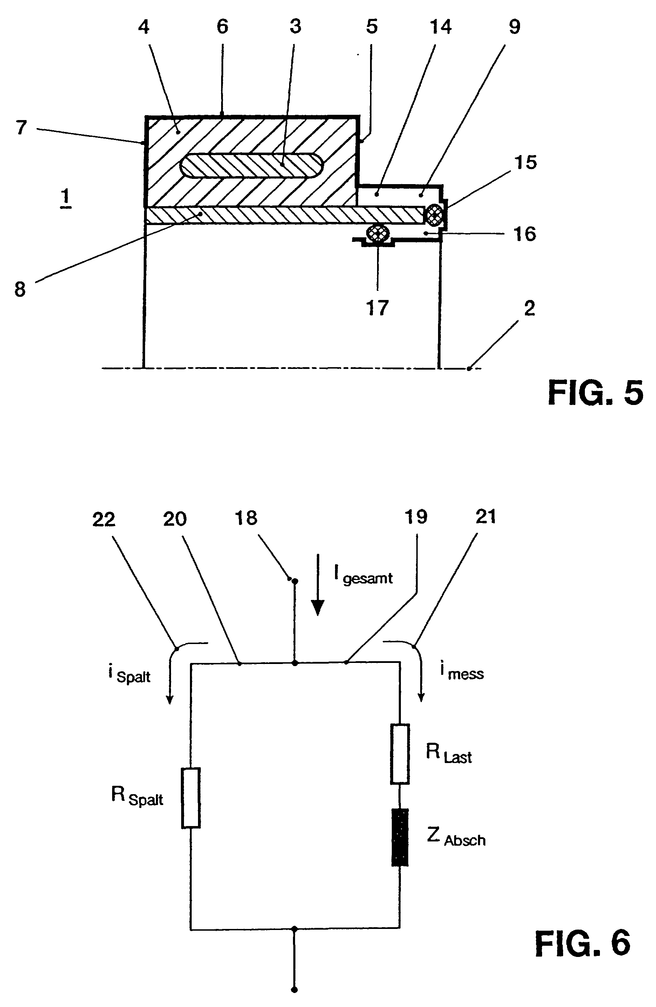

Die Fig. 5 zeigt einen Schnitt durch eine schematisch dargestellte vierte Ausführungsform eines erfindungsgemässen Stromwandlers 1. Bei diesem Stromwandler 1 ist der die Rogowskispule 3 umgebende ringförmige Hohlraum vollständig mit der isolierenden Masse 4 ausgefüllt. Ein erster Abschnitt 14 des labyrinthförmig ausgebildeten Spalts 9 ist hier mit einem Gas, beispielsweise mit Luft, gefüllt. Eine beispielsweise als elastischer Rundschnurring ausgebildete Dichtung 15 aus elektrisch isolierendem Material trennt den ersten Abschnitt 14 von einem zweiten Abschnitt 16 des Spalts 9 gasdicht ab. Der zweite Abschnitt 16 ist gegenüber dem isoliergasgefüllten Innenraum der metallgekapselten gasisolierten Schaltanlage mit einer weiteren Dichtung 17 abgeschlossen. Der zweite Abschnitt 16 ist mit Schwefelhexafluorid (SF$_6$) oder einem anderen Isoliergas gefüllt. Die Dichtung 17 ist aus einem elektrisch leitenden oder halbleitenden Material gefertigt, beispielsweise in der Form eines elastischen Rundschnurrings. Diese Ausführungsform kann auch durch das Weglassen der Dichtung 15 etwas vereinfacht werden. In diesem Fall wird der gesamte Innenraum des Spalts 9 mit einem Gas, beispielsweise mit Luft, gefüllt.

Zur Erläuterung der Wirkungsweise wird nun die Fig.6 betrachtet, die ein stark vereinfachtes elektrisches Ersatzschaltbild eines erfindungsgemässen Stromwandlers 1 zeigt. Das Ersatzschaltbild weist einen Eingang 18 auf, durch den der Strom I$_{gesamt}$ in die Ersatzschaltung fliesst, und zwei zueinander parallele Zweige 19 und 20. Durch den Zweig 19 fliesst, wie ein Pfeil 21 andeutet, der Strom i$_{mess}$, durch den Zweig 20 fliesst der Strom i$_{Spalt}$ wie ein Pfeil 22 andeutet. Dieser Strom i$_{Spalt}$, der durch den Einfluss der hochfrequenten Störung generiert wurde, fliesst durch den Zweig 20 an der Rogowskispule 3 vorbei, sodass diese für die Messung nur durch den durch den Zweig 19 fliessenden Strom i$_{mess}$ beaufschlagt wird. Die hochfrequente Störung wird bei diesem Stromwandler 1 demnach völlig unschädlich gemacht, wobei die Messwerterfassung im Zweig 19 unbeeinflusst weiter erfolgt. Der Zweig 19 ist mit einer Reihenschaltung eines ohmschen Widerstands R$_{Last}$ mit einer Impedanz Z$_{Absch}$ beschaltet. Der Widerstand R$_{Last}$ ist ein Ersatzwiderstand, der zwischen den Rändern des Spaltes 9 auftritt, und der durch den transformierten Eingangswiderstand der dem Stromwandler 1 nachgeschalteten Signalverarbeitungsvorrichtung hervorgerufen wird. Die Impedanz Z$_{Absch}$ ist überwiegend induktiv und ist als Impedanz der Abschirmung, die über dem Spalt 9 in der Abschirmung auftritt, anzusehen. Sowohl R$_{Last}$ als auch Z$_{Absch}$ lassen sich, wie nachfolgend beschrieben wird, aus den geometrischen Abmessungen des Stromwandlers 1 bestimmen. Der ohmsche Widerstand R$_{Spalt}$ dagegen wird mit Hilfe von zwei nachfolgend aufgeführten Bedingungen, welche seine Abhängigkeit von R$_{Last}$ und Z$_{Absch}$ definieren, bestimmt.

Folgende Berechnungsformeln sind massgebend:

$$R_{Last} = \frac{(2\pi \cdot F \cdot M_{Rog})^2}{R_{Elektr}} \qquad (1A)$$

Dabei ist:     R$_{Last}$, ein Ersatzwiderstand, der zwischen den Rändern des Spaltes 9 auftritt und der durch den transformierten Eingangswiderstand der Signalverarbeitungsvorrichtung hervorgerufen wird;

F, die Arbeitsfrequenz des Stromwandlers;

M$_{Rog}$, die Konstante der Rogowskispule;

R$_{Elektr}$, die Eingangsimpedanz der Signalverarbeitungsvorrichtung, d.h. die Last, welche die Rogowskispule belastet.

Die Induktivität L$_{Absch}$ der die Rogowskispule 3 umgebenden Abschirmung wird nach der folgenden Formel berechnet:

$$L_{Absch} = \frac{\mu_0 \cdot b \cdot \ln\left(\frac{D}{d}\right)}{2\pi} \qquad (2A)$$

Dabei ist: $\mu_0$, die magnetische Konstante (= $4\pi \cdot 10^{-7}$·H/m);

b, die axiale Ausbreitung der Abschirmung;

D, der Aussendurchmesser der Abschirmung;

d, der Innendurchmesser der Abschirmung.

Die überwiegend induktive Impedanz der Abschirmung $Z_{Absch}$, die über dem Spalt 9 in der Abschirmung auftritt, wird nach der folgenden Formel berechnet:

$$Z_{Absch} = 2 \cdot \pi \cdot F \cdot L_{Absch} \qquad (3A)$$

Für die Festlegung des Betrages des parallelgeschalteten ohmschen Widerstands $R_{Spalt}$ sind die folgenden beiden Bedingungen massgebend:

Erste Bedingung:

$$R_{Spalt} \geq \frac{R_{Last}}{\delta} \qquad (4A)$$

Dabei ist: $\delta$, die vorgegebene Messgenauigkeit.

Zweite Bedingung:

$$R_{Spalt} > \frac{Z_{Absch}}{\sqrt{\delta}} \qquad (5A)$$

Diese beiden Bedingungen müssen erfüllt sein, wenn der Widerstand $R_{Spalt}$ einen technisch sinnvollen Wert aufweisen soll, wenn also eine auch im Bereich hoher Frequenzen sehr gut wirksame Abschirmung geschaffen werden soll.

Die erste Bedingung (4A) stellt sicher, dass der diese Bedingung erfüllende ohmsche Widerstand $R_{Spalt}$ bei normalem Betrieb des Stromwandlers 1, also bei einer Betriebsfrequenz im Bereich um 50 Hz, praktisch keinen oder nur einen vernachlässigbaren Strom $i_{Spalt}$ führt. Der Strom $i_{Spalt}$ ist in diesem Fall in Phase mit dem Strom der durch den Eingangswiderstand der Signalverarbeitungsvorrichtung fliesst. Der Widerstand $R_{Spalt}$ ist bei dieser Frequenz wesentlich grösser als der ohmsche Widerstand $R_{Last}$ der zu diesem Widerstand $R_{Spalt}$ parallel geschalteten Abschirmung. Wird die vorgegebene Messgenauigkeit 6 mit beispielsweise 1/1000 angesetzt, so ergibt sich aus der ersten Bedingung (4A), dass der Widerstand $R_{Spalt}$ etwa tausendfach grösser sein muss als der Widerstand $R_{Last}$.

Die zweite Bedingung (5A) berücksichtigt den Einfluss der überwiegend induktiven Impedanz $Z_{Absch}$ der Abschirmung, die über dem Spalt 9 in der Abschirmung auftritt. Diese überwiegend induktive Impedanz verursacht eine Phasenverschiebung von etwa 90°. Wird auch hier die vorgegebene Messgenauigkeit $\delta$ mit beispielsweise 1/1000 angesetzt, so ergibt sich aus der zweiten Bedingung (5A), dass der Widerstand $R_{Spalt}$ etwa dreissigfach grösser sein muss als der Widerstand $R_{Last}$.

Von diesen beiden Bedingungen ist stets diejenige massgebend, die für den jeweiligen Fall jeweils die schärfere ist.

Die von der Rogowskispule 3 in die Signalverarbeitungsvorrichtung abgegebene vergleichsweise kleine Leistung $P_{Last}$ ist durch die folgende Gleichung bestimmt:

$$P_{Last} = \frac{(U_{Spule})^2}{R_{Elektr}} \qquad (6A)$$

Zudem gilt die Amplitudenregel:

$$\left|\frac{di_{mess}}{dt}\right| = 2\pi F \cdot i_{mess} \qquad (7A)$$

Dabei ist: $di_{mess}/dt$, die zeitliche Ableitung eines Stromes $i_{mess}$, der dem Strom entspricht, der durch den den Stromwandler durchdringenden Innenleiter fliesst;

$i_{mess}$, die Amplitude des Stroms, die der Amplitude des Stroms entspricht, der durch den den Stromwandler durchdringenden Innenleiter fliesst.

Die folgende Formel gibt die in der Rogowskispule 3 induzierte Spannung $U_{Spule}$ an:

$$U_{Spule} = M_{Rog} \cdot \frac{di_{mess}}{dt} \qquad (8A)$$

Der Widerstand $R_{Last}$ lässt sich nach folgender Gleichung rechnen:

$$R_{Last} = \frac{P_{Last}}{i_{mess}^2} \qquad (9A)$$

Werden die Gleichungen (6A), (7A) und (8A) mit der Gleichung (9A) verknüpft, so ergibt sich daraus die Gleichung (1A) für die Bestimmung des Widerstandes $R_{Last}$. Dabei wird davon ausgegangen, dass der Strom, der durch die Kapselung der gasisolierten Schaltanlage fliesst, gleich dem durch ihren Innenleiter fliessenden Strom ist. Der Widerstand $R_{Last}$ stellt einen Teil der Impedanz dar, die für die Umsetzung der Energie im Eingangswiderstand der zum Spalt 9 parallel geschalteten Signalverarbeitungsvorrichtung verantwortlich ist.

Bei einem ohmschen Widerstand $R_{Spalt}$ von $0,2\,m\Omega$ wirkt dieser bei einer Frequenz einer ankommenden hochfrequenten Störung von etwa 1MHz mit einer Dämpfung von 52 dB und bei einer Frequenz einer ankommenden extrem hochfrequenten Störung von etwa 100MHz mit einer Dämpfung von 150 dB. Diese äusserst wirksame Dämpfung verhindert zuverlässig eine schädliche Beeinflussung der durch die Rogowskispule 3 aufgenommenen Messwerte.

Die in der Ausführungsform gemäss Fig.3 den Spalt 9 auffüllende halbleitende Masse 11 weist einen spezifischen Widerstand $\sigma$ auf, der nach der folgenden Formel berechnet wird:

$$\sigma = \frac{R_{Spalt} \cdot p \cdot 2k}{s} \qquad (10A)$$

Dabei ist: p, der Umfang des Stromwandlers 1;
2k, die Gesamtlänge des Spaltes 9;
s, die Breite des Spaltes 9.

Mit $R_{Spalt} = 0,2\ m\Omega$, p = 1000mm, 2k = 4mm und s = 2mm ergibt sich ein vergleichsweiser kleiner spezifischer Widerstand $\sigma$ von 400 $\mu\Omega$m. Bei ausführbaren Konstruktionen von entsprechenden Stromwandlern liegen die Werte des spezifischen Widerstands $\sigma$ vorteilhaft im Bereich von 100 $\mu\Omega$m bis 1 $m\Omega$m.

Stromwandler, die entsprechend dem hier beschriebenen Prinzip aufgebaut sind, lassen sich, entsprechend modifiziert, auch in Freiluftschaltanlagen, die für hohe und höchste Betriebsspannungen ausgelegt sind, und in Mittelspannungsanlagen einsetzen, insbesondere sind sie auch in Schaltanlagen einsetzbar, die mit vergleichsweise grossen Strömen betrieben werden. Ferner lassen sich derartige Stromwandler mit vergleichsweise geringem Aufwand mit kapazitiven Spannungswandlern kombinieren, sodass ein einfach und günstig herzustellender kombinierter Strom- und Spannungswandler entsteht. Für metallgekapselte, gasisolierte Hochspannungsschaltanlagen sind derartige kombinierte Strom- und Spannungswandler besonders geeignet, da sie vergleichsweise geringe Abmessungen aufweisen.

**BEZUGSZEICHENLISTE**

| 1 | Stromwandler |
|---|---|
| 2 | Mittelachse |
| 3 | Rogowskispule |
| 4 | Masse |
| 5,6,7,8 | Wände |
| 9 | Spalt |
| 10 | ohmscher Widerstand |
| 11 | halbleitende Masse |
| 14 | Abschnitt |
| 15 | Dichtung |
| 16 | Abschnitt |
| 17 | Dichtung |
| 18 | Eingang |
| 19,20 | Zweig |
| 21,22 | Pfeil |

**Patentansprüche**

1. Stromwandler, insbesondere für eine metallgekapselte, gasisolierte Hochspannungsanlage, mit einem torusförmig ausgebildeten, eine Strombahn umschliessenden Stromsensor und mit einer diesem nachgeschalteten Signalverarbeitungsvorrichtung, mit einem den Stromsensor umgebenden und von einer elektrisch leitenden Abschirmung eingeschlossenen ringförmigen Hohlraum, der mit einer Masse (4) aufgefüllt ist, mit mindestens einem umlaufenden, als im störungsfreien Normalbetrieb des Stromwandlers (1) wirksame Unterbrechung der Abschirmung ausgelegten Spalt (9), dadurch gekennzeichnet,

    - dass der Spalt (9) labyrinthförmig ausgebildet ist, und
    - dass für die Überbrückung des mindestens einen Spalts (9) leitende oder halbleitende Mittel vorgesehen sind.

2. Stromwandler nach Anspruch 1, dadurch gekennzeichnet,

    - dass als leitendes Mittel diskrete ohmsche Widerstände (10) vorgesehen sind.

3. Stromwandler nach Anspruch 1, dadurch gekennzeichnet,

    - dass als leitende oder halbleitende Mittel entsprechend dotierte und den Spalt (9) füllende Kunststoffe vorgesehen sind.

4. Stromwandler nach Anspruch 1, dadurch gekennzeichnet,

    - dass als leitendes oder halbleitendes Mittel eine entsprechend dotierte, vorzugsweise als Rundschnurring ausgebildete, den Spalt (9) abschliessende Dichtung (17) vorgesehen ist.

**5.** Stromwandler nach einem der Ansprüche 1 bis 4, dadurch gekennzeichnet,

- dass als Stromsensor mindestens eine Rogowskispule (3) vorgesehen ist.

## Claims

**1.** Current transformer, in particular for a metal-enclosed gas-insulated high-voltage installation, having a toroidal current sensor enclosing a current path and having a signal processing system downstream of this sensor, having an annular cavity which surrounds the current sensor and is enclosed by an electrically conductive screen and which is filled with a compound (4), and having at least one circumferential gap which is in the form of an interruption in the screen that acts during interference-free normal operation of the current transformer (1), characterized

- in that the gap (9) is of labyrinth-type design, and
- in that conductive or semiconductive means are provided for bridging the at least one gap (9).

**2.** Current transformer according to Claim 1, characterized

- in that the discrete non-reactive resistors (10) are provided as conductive means.

**3.** Current transformer according to Claim 1, characterized

- in that suitably doped plastic materials which fill the gap (9) are provided as the conductive or semiconductive means.

**4.** Current transformer according to Claim 1, characterized

- in that a suitably doped seal (17) which is preferably designed as a cord-packing ring and seals the gap (9) is provided as the conductive or semiconductive means.

**5.** Current transformer according to one of Claims 1 to 4, characterized

- in that at least one uniform-field coil (3) is provided as the current sensor.

## Revendications

**1.** Convertisseur de courant, notamment pour un équipement à haute tension en boîtier métallique à isolement gazeux, avec un capteur de courant de forme toroïdale entourant une voie de courant et un dispositif de traitement du signal branché en aval de celui-ci, avec un espace creux de forme annulaire rempli d'une masse (4) qui entoure le capteur de courant et qui est fermé par un blindage conducteur d'électricité, avec au moins une fente (9) périphérique conçue sous la forme d'une interruption du blindage agissant lors du fonctionnement normal sans perturbation du capteur de courant (1), caractérisé en ce
que la fente (9) a la forme d'un labyrinthe et
que des moyens conducteurs ou semiconducteurs sont prévus pour court-circuiter l'au moins une fente (9).

**2.** Convertisseur de courant selon la revendication 1, caractérisé en ce que les moyens conducteurs prévus sont des résistances ohmiques discrètes (10).

**3.** Convertisseur de courant selon la revendication 1, caractérisé en ce que les moyens conducteurs ou semiconducteurs prévus sont des matières plastiques dopées en conséquence et remplissant la fente (9).

**4.** Convertisseur de courant selon la revendication 1, caractérisé en ce que le moyen conducteur ou semiconducteur prévu est un joint dopé en conséquence, de préférence réalisé sous la forme d'un joint torique, et fermant la fente (9).

**5.** Convertisseur de courant selon l'une des revendications 1 à 4, caractérisé en ce que le capteur de courant prévu est au moins une bobine de Rogowski (3).

FIG. 1

FIG. 2

FIG. 3

FIG. 4

**FIG. 5**

**FIG. 6**